# FASCICULE DE BREVET EUROPEEN

(11) **EP 3 404 682 B1**
(45) Date de publication et mention de la délivrance du brevet: **27.11.2019**
(21) Numéro de dépôt: 18169975.2
(22) Date de dépôt: 27.04.2018
(51) Int. Cl.: H01H 13/85, B60W 50/16

(54) **ENSEMBLE DE COMMANDE PAR CONTACT GLISSANT D'UN PANNEAU DE COMMANDE POUR VÉHICULE AUTOMOBILE**
BEDIENEINHEIT MIT GLEITKONTAKT EINES BEDIENUNGSFELDS FÜR KRAFTFAHRZEUGE
OPERATION ASSEMBLY BY SLIDING CONTACT OF A CONTROL PANEL FOR A MOTOR VEHICLE

(30) Priorité: 18.05.2017 FR 1754425
(43) Date de publication de la demande: 21.11.2018
(73) Titulaire: Aptiv Technologies Limited, St. Michael (BB)
(72) Inventeur: POLAK, Andrzej, 50354 Huerth (DE)
(74) Mandataire: Vigand, Philippe

(56) Documents cités:
- DE-A1-102008 035 907
- DE-A1-102013 226 922
- DE-A1-102014 019 006
- JP-A- 2006 107 140
- US-A1- 2007 236 450
- US-A1- 2010 053 087
- US-A1- 2010 250 071

## Description

### DOMAINE TECHNIQUE

La présente invention concerne un ensemble de commande par contact glissant d'un panneau de commande pour véhicule automobile et plus particulièrement une touche de commande par glissement de doigt d'un opérateur avec retour de force.

### ARRIERE-PLAN TECHNOLOGIQUE DE L'INVENTION

Les occupants d'une automobile sont très sensibles à l'aspect visuel et au toucher des touches de commande d'un panneau de commande.

Généralement, les touches de commandes par contact glissant, et à retour de force c'est-à-dire pour lesquelles un glissement d'un doigt sur la zone de commande de la touche est détecté et confirmé par un effet haptique, comprennent des interrupteurs mécaniques conventionnels constitués de pièces mobiles. Généralement des solutions conventionnelles telles que des boutons poussoir à ressort sont utilisés pour générer un effet haptique.

Les panneaux de commande équipés de telles touches de commande par contact glissant sont généralement encombrants et complexes à fabriquer.

Il est donc important de proposer une solution nouvelle résolvant ces problèmes.

Le document DE 10 2014 019006 A1 expose un ensemble de commande par contact glissant pour véhicule automobile ainsi qu'une méthode correspondante de commande d'un ensemble de commande par contact glissant.

### RESUME DE L'INVENTION

Selon l'invention, un ensemble de commande par contact glissant pour véhicule automobile comprend un support; une carte à circuit imprimé agencée sur le support; un élément de commande recouvrant la carte à circuit imprimé et comprenant une zone de commande par glissement d'un doigt d'un opérateur; la carte à circuit imprimé comprenant une première série de détecteurs de position configurée pour déterminer la position et la direction de glissement du doigt d'un opérateur, la première série de détecteurs de position étant montée en appui contre l'élément de commande en vis-à-vis de la zone de commande par glissement. La carte à circuit imprimé comprend au moins un premier élément de détection étant à la fois un capteur de force d'appui et un actionneur haptique, le premier élément de détection étant intercalé en appui entre la carte à circuit imprimé et un organe de liaison, l'organe de liaison étant en contact direct avec l'élément de commande.

La carte à circuit imprimé comprend une première découpe formant une première languette élastique sur laquelle est agencé le premier élément de détection. Chaque élément de détection est un élément piézoélectrique.

La première série de détecteurs de position peut comprendre des capteurs à détection capacitive. La carte à circuit imprimé peut être globalement rectangulaire selon un axe longitudinal et un axe transversal, l'élément de commande peut comprendre une plaque de commande globalement rectangulaire sur laquelle la zone de commande s'étend longitudinalement de sorte à détecter un glissement de doigt sur la zone de commande selon la direction longitudinale.

La zone médiane transversale de la carte à circuit imprimé peut être agencée en appui sur une barre de support transversale comprenant un profil saillant sur le support et en les extrémités transversales de la carte à circuit imprimé peuvent être plaquées sur le support de sorte que la carte à circuit imprimé présente un profil courbé.

Une seconde série de détecteurs de position peut être agencée symétriquement à la première série de détecteurs de position par rapport à la médiane transversale de la carte à circuit imprimé et un second élément de détection peut être agencé symétriquement au premier élément de détection par rapport à la médiane transversale de la carte à circuit imprimé.

La carte à circuit imprimé peut comprendre une seconde découpe formant une seconde languette élastique sur laquelle est agencé le second élément de détection. L'organe de liaison peut comprendre un premier bras d'appui venu de matière avec l'élément de commande et agencé contre le premier élément de détection et le second élément de détection.

L'ensemble de commande peut comprendre un troisième élément de détection et un quatrième élément de détection agencés respectivement symétriquement au premier élément de détection et au second élément de détection, par rapport à la médiane longitudinale de la carte à circuit imprimé.

La carte à circuit imprimé peut comprendre une troisième découpe et une quatrième découpe formant une troisième languette élastique et une quatrième languette élastique sur lesquelles sont agencés le troisième élément de détection et le quatrième élément de détection.

L'organe de liaison peut comprendre un second bras d'appui venu de matière avec l'élément de commande et agencé contre le troisième élément de détection et le quatrième élément de détection. L'organe de liaison peut comprendre au moins un détecteur de position. L'organe de liaison peut comprendre au moins une barre de support ayant un profil saillant sur le support, chaque élément de détection pouvant être agencé sur une barre de support, l'élément de commande comprenant des moyens de fixation avec le support.

Les moyens de fixations peuvent être des tiges de maintien s'étendant depuis l'élément de commande jusqu'à leur extrémité libre, chaque extrémité libre comprenant un ergot venant s'agencer au travers d'ouvertures du support et venant en butée contre la face inférieure du support de sorte à maintenir la carte à circuit imprimé comprimée entre l'élément de commande et le support.

Selon l'invention, un module électronique de plafond d'habitacle de véhicule automobile comprend l'ensemble de commande décrit ci-dessus.

Selon l'invention, une méthode de commande d'un ensemble de commande par contact glissant tel que décrit ci-dessus, comprend les étapes de :
déterminer l'appui d'un doigt sur la zone de commande au moyen d'un capteur à détection capacitive ;
valider l'appui du doigt sur la zone de commande au moyen d'un élément piézoélectrique ;
déterminer la force d'appui du doigt sur la zone de commande au moyen de l'élément piézoélectrique ;
détecter le glissement d'un doigt sur la zone de commande au moyen d'une série de capteurs à détection capacitive ;
générer un signal haptique d'acquittement du glissement du doigt sur la zone de commande au moyen de l'élément piézoélectrique ;
activer une commande du véhicule en fonction de la course de glissement du doigt sur la zone de commande.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique partielle en perspective et en coupe transversale d'un panneau de commande comprenant un ensemble de commande par contact glissant selon un premier mode de réalisation.
- La figure 2 est une vue éclatée en perspective de l'ensemble de commande par contact glissant de la figure 1.
- La figure 3 est une vue schématique partielle en perspective et en coupe transversale du panneau du commande comprenant l'ensemble de commande par contact glissant selon un second mode de réalisation.
- La figure 4 est une vue éclatée en perspective de l'ensemble de commande par contact glissant de la figure 3.
- La figure 5 est une vue schématique partielle en perspective et en coupe transversale du panneau du commande comprenant l'ensemble de commande par contact glissant selon un troisième mode de réalisation.
- La figure 6 est une vue éclatée en perspective de l'ensemble de commande par contact glissant de la figure 5.
- La figure 7 est une vue schématique partielle en perspective et en coupe transversale du panneau du commande comprenant l'ensemble de commande par contact glissant selon un quatrième mode de réalisation.
- La figure 8 est une vue éclatée en perspective de l'ensemble de commande par contact glissant de la figure 7.
- La figure 9 est une vue schématique d'un module électronique de plafond de véhicule comprenant le panneau de commande équipé d'un ensemble de commande par contact glissant selon l'un quelconque des modes de réalisation des figures précédentes.

### DESCRIPTION DES MODES DE REALISATION PREFERES

Afin de faciliter la description, et de façon non limitative, un repère orthogonal comprenant un axe longitudinal L, un axe transversal T et un axe vertical V est défini. Des orientations « bas », « haut », « dessus », « dessous », « inférieure » et « supérieure » sont définies selon la direction verticale. Des orientations « gauche », « droite » et « latérale » sont définies selon la direction transversale. Des orientations « avant » et « arrière » sont également définies selon la direction longitudinale.

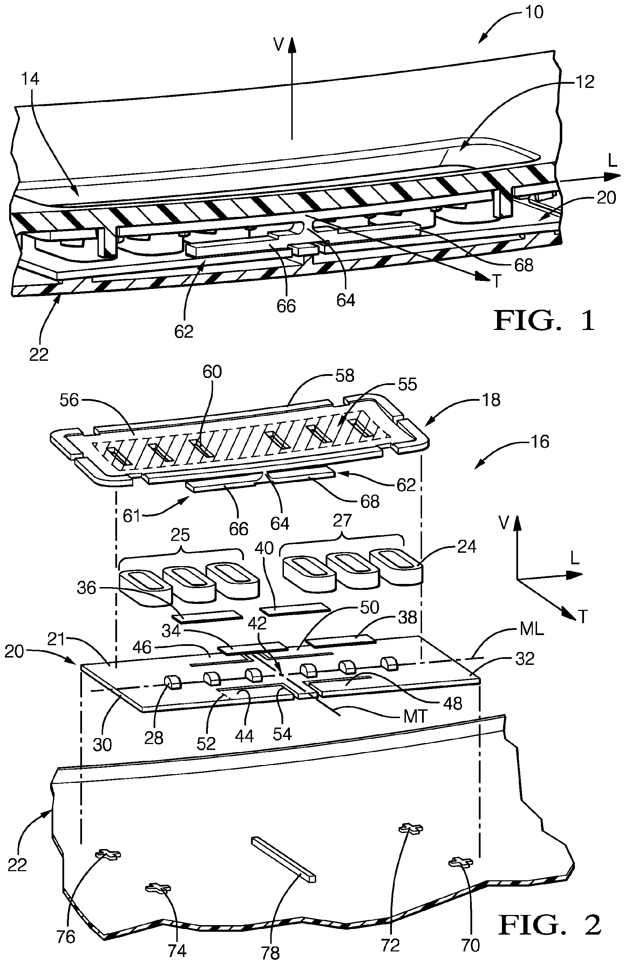

Selon la figure 1, un panneau de commande 10 pour véhicule automobile comprend une touche de commande 12 par contact glissant selon l'axe longitudinal L. On entend par touche de commande 12 par contact glissant, une touche de commande 12 pour laquelle le glissement d'un doigt d'un opérateur sur la touche est détecté et active une fonction du véhicule. Le panneau de commande 10 comprend une ouverture 14 dans laquelle la touche de commande 12 est agencée, permettant ainsi à l'opérateur d'accéder à la touche de commande 12 par contact glissant.

Selon le mode de réalisation représenté, le glissement du doigt sur la touche de commande doit être appliqué selon l'axe longitudinal.

Selon la figure 1 et la figure 2, un premier mode de réalisation de la touche de commande 12 est représenté. La touche de commande 12 est constituée d'un ensemble de commande 16 comprenant un élément de commande 18 et une carte à circuit imprimé 20 agencée sur un support 22.

La carte à circuit imprimé 20 est globalement de forme rectangulaire. La carte à circuit imprimé 20 comprend une série de détecteurs de position 24 ainsi que des éléments de détection combinant les propriétés d'un capteur de force d'appui et également d'actionneur haptique. Plus particulièrement, la série de détecteurs de position 24 comprend des capteurs de type capteur à détection capacitive et les éléments de détection 34 sont des éléments piézoélectriques. Les éléments piézoélectriques sont prévus pour agir comme des capteurs de force d'appui de sorte que leur déformation mécanique par un appui peut être convertie en signal électrique. Les éléments piézoélectriques sont également prévus pour agir comme un actionneur haptique de sorte que leur stimulation par un signal électrique peut engendrer leur vibration, les vibrations étant ressenties comme un retour de force par le doigt de l'opérateur.

Selon le mode de réalisation représenté, les détecteurs de position 24 sont agencés alignés consécutivement l'un après l'autre selon la direction longitudinale sur la face de dessus 21 de la carte à circuit imprimé 20. Plus particulièrement, les détecteurs de position 24 sont agencés sur la médiane longitudinale ML de la carte à circuit imprimé 20. De façon non limitative, les détecteurs de position 24 sont au nombre de six. Les six détecteurs de position 24 sont globalement régulièrement répartis en un premier groupe 25 de trois détecteurs de position 24 s'étendant entre une première extrémité transversale 30 de la carte à circuit imprimé 20 et la médiane transversale MT de la carte à circuit imprimé 20 et en un second groupe 27 de trois détecteurs de position 24 s'étendant entre la médiane transversale MT de la carte à circuit imprimé 20 et la seconde extrémité transversale 32 de la carte à circuit imprimé 20.

les détecteurs de position 24 sont de forme annulaires et sont donc également prévus pour servir de guide de lumière aux faisceaux lumineux de sources de lumière 28 montées sur la carte à circuit imprimé 20. Les sources de lumières 28 sont donc chacune entourée par un détecteur de position 24.

De façon non limitative, les éléments de détection 34, 36, 38, 40 sont des éléments piézoélectriques de frome globalement rectangulaire agencés sur la face de dessus 21 de la carte à circuit imprimé 20. Les éléments de détection 34, 36, 38, 40 sont au nombre de quatre. Les éléments de détection 34 sont repartis en une première paire d'éléments de détection 34, 36 agencée longitudinalement symétriquement par rapport à la médiane longitudinale ML en bordure longitudinale de la carte circuit imprimé 20. Les éléments de détection 34, 36, 38, 40 sont également répartis en une seconde paire d'éléments de détection 38, 40 agencée symétriquement à la première paire 34, 36 par rapport à la médiane transversale MT de la carte à circuit imprimé 20. Plus particulièrement, les quatre éléments de détection 34, 36, 38, 40 sont agencés à proximité immédiate de la médiane transversale MT de la carte à circuit imprimé 20. Les deux paires d'éléments de détections 34, 36, 38, 40 sont donc séparées l'une de l'autre par une zone de la carte à circuit imprimé s'étendant selon la médiane transversale MT de la carte à circuit imprimé. Cette zone sera dénommée zone médiane transversale 42 de la carte à circuit imprimé 20.

De façon particulière, chaque élément de détection 34, 36, 38, 40 est agencé sur une languette élastique 44, 46, 48, 50 de la carte à circuit imprimé 20. Chaque languette 44, 46, 48, 50 est obtenue par une découpe de la carte à circuit imprimé 20. Chaque languette 44, 46, 48, 50 est globalement de forme rectangulaire comprenant trois bordures délimitées par un évidement de matière et une extrémité de jonction 52 avec la carte à circuit imprimé 20. Chaque languette 44, 46, 48, 50 s'étend longitudinalement depuis leur extrémité de jonction 52 avec la carte à circuit imprimé 20 jusqu'à leur extrémité libre 54. Les extrémités libres 54 des languettes 44, 46, 48, 50 sont agencées directement en vis-à-vis de la médiane transversale MT de la carte à circuit imprimé 20. Chaque languette 44, 46, 48, 50 est de dimension, c'est-à-dire de longueur, selon l'axe longitudinal L, et de largeur, selon l'axe transversal T, du même ordre de grandeur que l'élément de détection 34, 36, 38, 40 agencé sur ladite languette 44, 46, 48, 50.

De la même façon que les éléments de détection 34, 36, les languettes 44, 46 sur lesquelles sont agencées la première paire d'élément de détection 34, 36 sont symétriques entre elles par rapport à la médiane longitudinale ML de la carte à circuit imprimé 20; les languettes 48, 50 sur lesquelles sont agencées la seconde paire d'élément de détection 38, 40 sont symétriques, par rapport à la médiane transversale MT de la carte à circuit imprimé 20, aux languettes 48, 50 sur lesquelles est agencée la première paire d'élément de détection 34, 36.

L'élément de commande 18 comprend une zone de commande 55 par glissement du doigt de l'opérateur. La zone de commande 55 par glissement du doigt de l'opérateur est identifiée sur la figure 1 par une zone hachurée. La zone de commande 55 est agencée sur une plaque de commande 56 de l'élément de commande 18 de forme globalement rectangulaire. La série de détecteurs de position 24, c'est-à-dire le premier groupe 25 et le second groupe 27, est montée en appui contre la plaque de commande 56 en vis-à-vis de la zone de commande 55 par glissement de sorte que le glissement d'un doigt sur la zone de commande 55 soit détecté par les détecteurs de position 24. L'élément de commande 18 comprend, en périphérie de la plaque de commande 56, une paroi 58 permettant son assemblage dans l'ouverture 14 du panneau de commande 10. La paroi 58 forme un joint d'étanchéité entre le panneau de commande 10 et la touche de commande 12.

L'élément de commande 18 comprend sur la zone de commande par glissement 55, des ouvertures 60 prévues pour être rétro éclairées par les sources de lumière 28. Les ouvertures 60 prévues pour être rétro éclairer peuvent également être remplacées par des pictogrammes.

L'élément de commande 18 comprend également des bras d'appui 62 reposant sur les éléments de détection 34, 36, 38, 40. Les bras d'appui 62 sont au contact permanent sur les éléments de détection 34, 36, 38, 40. Selon le mode de réalisation représenté, l'élément de commande 18 comprend deux bras d'appui 62 (un seul est visible), chaque bras d'appui 62 étant au contact de deux éléments de détection 34, 38 agencés en vis-à-vis de part et d'autre de la médiane transversale MT de la carte à circuit imprimé 20. Chaque bras d'appui 62 à globalement la forme d'un 'T' retourné. Chaque tige centrale 64 de chaque 'T'est agencée verticalement sur chaque rebord longitudinale de la plaque de commande 56, au niveau de la médiane transversale MT de la carte à circuit imprimé 20. La tige centrale 64 s'étend verticalement vers le bas vers la zone médiane transversale de la carte à circuit imprimé 20. La tige centrale 64 verticale comprend deux barres horizontales 66, 68 s'étendant longitudinalement de part et d'autre de la tige centrale 64. Chaque barre horizontale 66, 68 est agencée en appui sur un élément de détection 34, 38 de sorte que deux éléments de détection 34, 38 agencés en vis-à-vis de part et d'autre de la zone médiane transversale 42 de la carte à circuit imprimé 20 sont en appui contre les deux barres horizontales 66, 68 du 'T' retourné.

La partie du 'T' retourné en vis-à-vis de la zone médiane transversale 42 de la carte à circuit imprimé 20 ne vient pas au contact de la zone médiane 42 de la carte à circuit imprimé 20. En d'autres termes, les deux barres horizontales 66, 68 du 'T' retourné présentent donc un profil en marche montante au niveau de leur jonction avec la tige verticale 64 de sorte à n'être en appui que sur les éléments de détection 34, 38 et pas en appui sur la zone médiane 42 de la carte à circuit imprimé 20.

Chaque barre horizontale 66, 68 est de longueur, selon l'axe longitudinal L, similaire à la longueur de l'élément de détection 34, 38 sur lequel la barre horizontale 66, 68 est en appui. L'élément de commande 18 est moulé d'une seule pièce; en d'autres termes, les bras d'appui 62 de l'élément de commande 18 sont venus de matière avec la plaque de commande 56.

La carte à circuit imprimé 20 est agencée sur le support 22. Plus particulièrement le support 22 comprend quatre plots de maintien 70, 72, 74, 76 de la carte à circuit imprimé 20. Les plots de maintien 70, 72, 74, 76, venus de matière avec le support, sont disposés de sorte à être agencés globalement aux quatre coins de la carte à circuit imprimé 20. De façon particulière, les plots de maintien 70, 72, 74, 76 sont en forme de croix agencés à plat sur le support 22 et sur lesquels la carte à circuit imprimé 20 vient en appui. Les quatre plots de maintien 70, 72, 74, 76 sont globalement de hauteur, selon la direction verticale, identique.

La carte à circuit imprimé 20 vient également en appui sur une barre de support transversale 78 présentant un profil saillant sur le support 22. La barre de support transversale 78 est venue de matière avec le support 22. La carte à circuit imprimé 20 est en appui sur la barre de support transversale 78 tout le long de sa médiane transversale MT. La barre de support transversale 78 est de dimension suffisamment longue suivant la direction transversale pour être en appui sur la carte à circuit imprimé 20 tout le long de la médiane transversale MT. La barre de support transversale 78 est de hauteur, selon la direction vertical, légèrement supérieure aux quatre plots de maintien 70, 72, 74, 76.

Selon le mode de réalisation représenté à la figure 1, chaque extrémité transversale 30, 32 de la carte à circuit imprimé 20 vient en appui sur deux plots de maintien 70, 72, 74, 76, la zone médiane transversale 42 de la carte à circuit imprimé 20 vient en appui sur la barre de support transversale 78. De par la différence de hauteur entre les plots de maintien 70, 72, 74, 76 et la barre de support transversale 78, la carte à circuit imprimé 20 est agencée légèrement bombée sur le support 22. Afin de maintenir la carte à circuit imprimé 20 légèrement courbée sur le support 22, les plots de maintien 70, 72, 74, 76 peuvent comprendre des moyens d'accroche avec la carte à circuit imprimé 20. Alternativement, afin de maintenir la carte à circuit imprimé 20 légèrement courbée sur le support 22, l'ensemble de commande 16 peut être maintenu légèrement comprimé entre le panneau de commande 10 et un fond de boîtier relié mécaniquement au panneau de commande.

Selon le mode de réalisation représenté à la figure 1 et la figure 2, la série de détecteurs de position 24 permet d'identifier la position du doigt d'un opérateur sur la zone de commande 55 et de détecter le glissement du doigt. La perception par l'opérateur de la prise en compte de la commande effectuée par glissement de son doigt est perceptible par un retour de force généré par une vibration des éléments de détection 34, 36, 38, 40. Plus particulièrement, lorsque les détecteurs de position 24 ont détecté le glissement d'un doigt d'un opérateur sur la zone de commande par glissement 55, un signal électrique est appliqué sur les éléments de détection 34, 36, 38, 40 de sorte à les faire vibrer. Les éléments de détection 34, 36, 38, 40 étant en contact sur les bras d'appui 62 de l'élément de commande, un retour de force est donc perçu par l'opérateur. De plus, les sources lumineuses 28 de l'ensemble de commande 16 permettent d'illuminer la zone de commande 55 sur laquelle le doigt de l'opérateur a glissé.

Bien qu'il soit possible de ne pas agencer les éléments de détection 34, 36, 38, 40 sur des languettes élastiques 44, 46, 48, 50 de la carte à circuit imprimé 20, l'agencement particulier des éléments de détection 34, 36, 38, 40 sur les languettes élastiques 44, 46, 48, 50 permet d'amplifier leurs vibrations et donc d'accentuer le retour de force. L'agencement de la carte à circuit imprimé 20 légèrement surélevée par rapport au support 22, permet également d'accentuer l'amplitude des vibrations des éléments de détection 34, 36, 38, 40 sur les languettes élastiques 44, 46, 48, 50.

Les éléments de détection 34, 36, 38, 40 peuvent également permettre la détermination de la force d'appui sur la zone de commande 55. Cette caractéristique peut permettre, par exemple, d'attribuer plusieurs fonctions à la touche de commande 12 par glissement.

La force avec laquelle un opérateur fait glisser son doigt sur la zone de commande 55 est transmise aux éléments de détection 34, 36, 38, 40 grâce aux bras d'appui 62. Selon le mode de réalisation des bras d'appui en 'T'inversé, cette force se répercute au niveau de la zone médiane transversale 42 de la carte à circuit imprimé 20 et donc sollicite en particulier les éléments de détection 34, 36, 38, 40 au niveau de l'extrémité libre 54 des languettes élastiques 44, 46, 48, 50. La courbure de la carte à circuit imprimé 20 permet d'optimiser l'uniformité de la force appliquée sur les éléments de détection 34, 36, 38, 40 en fonction de la position du doigt d'un opérateur. En d'autres termes, cette courbure permet de limiter les erreurs d'acquisition de la force d'appui du doigt d'un opérateur quel que soit la position du doigt sur la zone de commande 55. Cependant il est possible de ne pas surélever la carte à circuit imprimé 20 et également de ne pas l'agencer de manière courbée, l'acquisition et la correction de la force d'appui en fonction de la position du doigt de l'opérateur pouvant être traitées par une unité de contrôle (non représentée) en liaison électrique avec l'ensemble de commande 16.

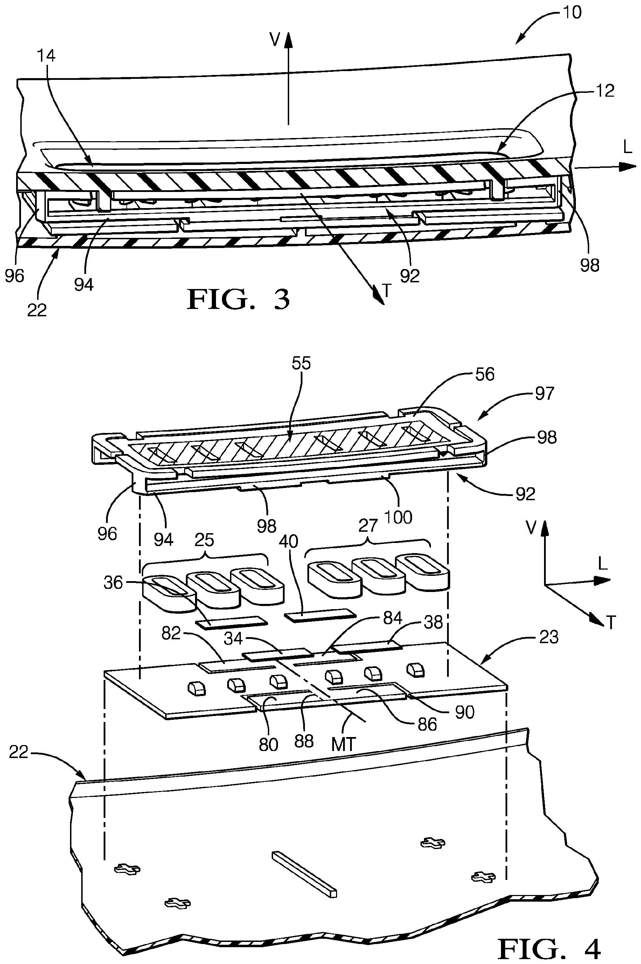

Selon la figure 3 et la figure 4, un second mode de réalisation est représenté. Ce mode de réalisation ne diffère de celui de la figure 1 et de la figure 2 qu'en ce que le bras d'appui 92 et les languettes élastiques 80, 82, 84, 86 ont des formes géométriques différentes.

Les languettes élastiques 80, 82, 84, 86 de ce mode de réalisation diffèrent uniquement du mode de réalisation précédent en ce que leur extrémité de jonction 88 et leur extrémité libre 90 ont été inter changées. En d'autres termes, les extrémités de jonction 88 de ces languettes élastiques 80, 82, 84, 86 sont agencées directement en vis-à-vis de la médiane transversale MT de la carte à circuit imprimé 23.

Bien que cet agencement de languettes élastiques 80, 82, 84, 86 puisse convenir au mode de réalisation précédemment décrit selon la figure 1 et la figure 2, cet agencement est optimum vis-à-vis de la structure des deux bras d'appui 92 (un seul bras est visible) de la figure 3 et de la figure 4.

Chaque bras d'appui 92 du mode de réalisation de la figure 3 et de la figure 4 comprend une barre de transfert d'appui 94 agencée longitudinalement parallèlement à une bordure longitudinale de la plaque de commande 56 de l'élément de commande 97 et s'étendant tout le long de la plaque de commande 56. La barre de transfert d'appui 94 est agencée sous la bordure longitudinale de la plaque de commande 56 et est reliée à chacune de ses extrémités à la bordure longitudinale de la plaque de commande 56 par une partie verticale 96, 98 formant une entretoise d'espacement avec la bordure longitudinale de la plaque de commande 56. La barre de transfert d'appui 94 est donc uniformément espacée avec la bordure longitudinale de la plaque de commande 56 de sorte à venir au plus proche de la carte à circuit imprimé 23 sans y être en contact.

Cependant, l'épaisseur, selon la direction verticale, de la barre de transfert d'appui est augmentée en vis-à-vis des éléments de détection 34, 36, 38, 40 de sorte à être en contact permanent avec les dits éléments de détection 34, 36, 38, 40. L'augmentation de l'épaisseur de la barre de transfert d'appui forme donc deux protubérances 98, 100 comprenant chacune une surface d'appui en contact permanent avec deux éléments de détection 80, 86 agencés de part et d'autre de la zone médiane transversale 42 de la carte à circuit imprimé 23.

La force avec laquelle un opérateur fait glisser son doigt sur la zone de commande 55 est transmise aux éléments de détection 34, 36, 38, 40 grâce aux bras d'appui 92. Selon le mode de réalisation des bras d'appui 92 comprenant une barre de transfert d'appui 94, cette force se répercute au niveau des parties verticales 96, 98 agencées aux extrémités des bordures longitudinales de la plaque de commande 56, et donc sollicite en particulier les éléments de détection 34, 36, 38, 40 au niveau de l'extrémité libre 90 des languettes élastiques 80, 82, 84, 86.

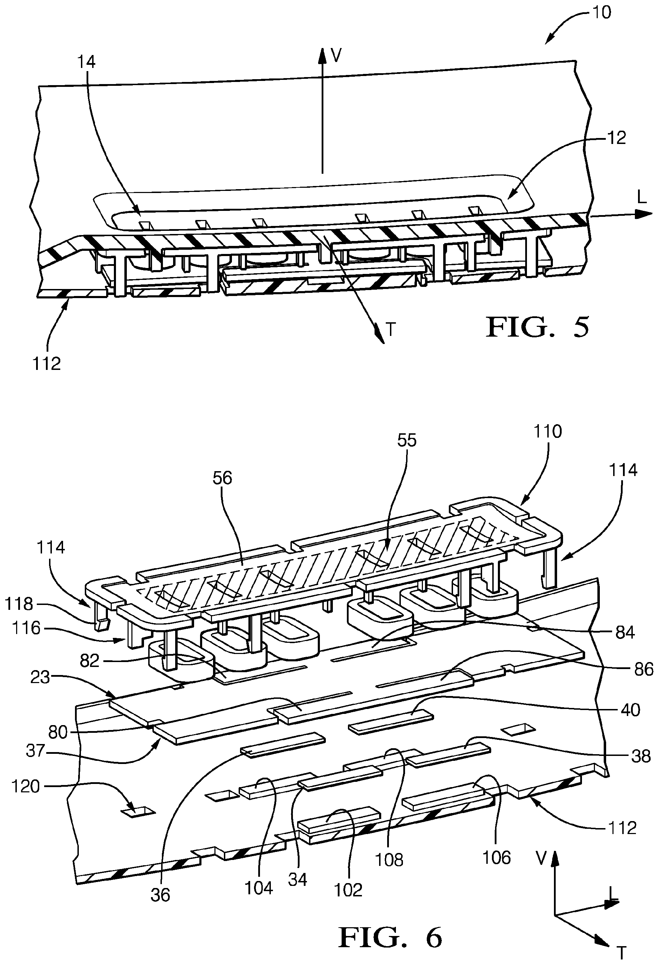

Selon la figure 5 et la figure 6, un troisième mode de réalisation est représenté. Ce mode de réalisation ne diffère de celui de la figure 3 et de la figure 4 qu'en ce que les éléments de détections 34, 36, 38, 40 sont agencés sur la face de dessous 37 de la carte à circuit imprimé 23, qu'en ce que l'élément de commande 110 ne comprend pas de bras d'appui, et que le support 112 ne comprend pas de barre de support transversale.

Selon ce mode de réalisation, le support 112 comprend quatre barres de support longitudinales 102, 104, 106, 108 agencées en vis-à-vis des languettes élastiques 80, 82, 84, 86 et de dimensions globalement identiques aux languettes élastiques 80, 82, 84, 86. Les quatre barres de support longitudinales 102, 104, 106, 108 présentent un profil saillant sur le support. Les quatre barres de support longitudinales 102, 104, 106, 108 sont venues de matière avec le support 112. Les éléments de détections 34, 36, 38, 40 sont agencés sur la face de dessous des languettes élastiques 80, 82, 84, 86 et sont en appui permanent sur les barres de support longitudinales 102, 104, 106, 108.

L'élément de commande 110 comprend des tiges de maintien 114 avec le support 112 et des tiges d'appui 116 de la carte à circuit imprimé contre le support. Plus particulièrement, la plaque de commande 56 comprend, le long de ses bordures longitudinales, des tiges de maintien 114 verticales dont l'extrémité libre forme un ergot de maintien 118 avec le support 112 venant en appui contre la face inférieure du support 112. L'ergot de maintien 118 de chaque tige de maintien 114 vient s'agencer au travers d'une ouverture 120 du support 112. De plus, la plaque de commande 56 comporte à chacune de ses deux extrémités transversales, une tige d'appui 116 verticale venant en appui contre la carte à circuit imprimé 23. D'autres tiges d'appui sont également agencées entre la plaque de commande 56 et la carte à circuit imprimé 23.

Selon ce mode de réalisation, la carte à circuit imprimé 23 est maintenue comprimée entre la plaque de commande 56 et le support 112. La carte à circuit imprimé 23 est également agencée courbée entre ses deux extrémités transversales puisqu'elle repose également sur les barres de support longitudinales 102, 104, 106, 108 présentant un profil saillant sur le support 112. Lors du glissement d'un doigt d'un opérateur sur la zone de commande 55 de l'élément de commande 110, la contrainte de force exercée par l'élément de commande 110 et par le support 112 sur la carte à circuit imprimé 23 est modifiée et est donc détectée par les éléments de détection 34, 36, 38, 40.

Lors de l'application d'un signal électrique sur les éléments de détection 34, 36, 38, 40, la vibration de ceux-ci entraine une vibration du support 112, ce dernier étant en contact direct avec l'élément de commande 110 grâce aux tiges de maintien 114. Les vibrations des éléments de détection 34, 36, 38, 40 sont donc perceptibles comme un retour de force au travers de la plaque de commande 56 par l'opérateur.

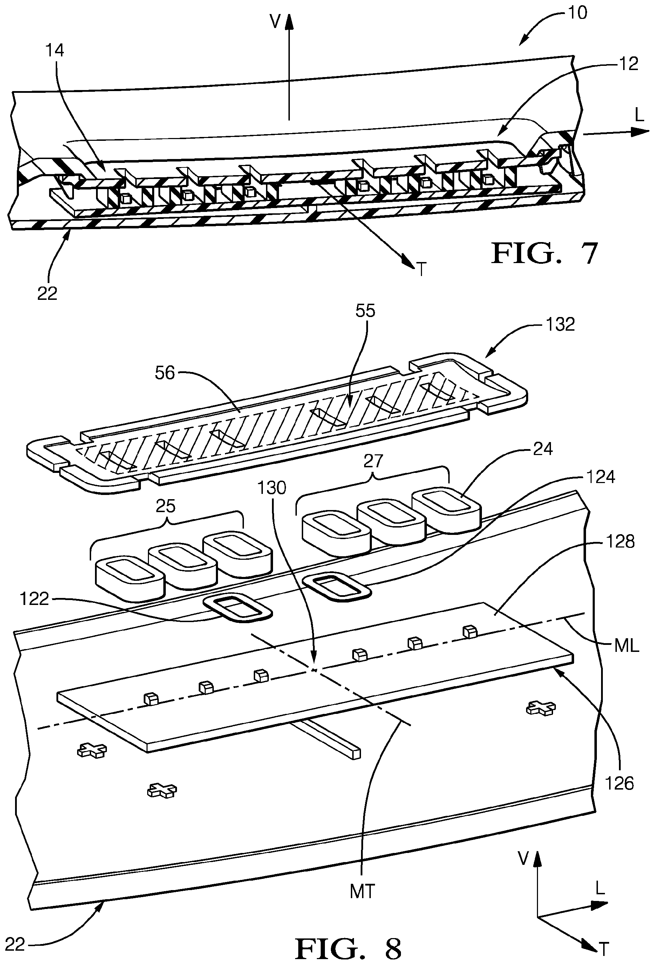

Selon la figure 7 et la figure 8, un quatrième mode de réalisation est représenté. Ce mode de réalisation particulier diffère du premier et du second mode de réalisation en ce que les éléments de détection 122, 124 sont agencés sur la sur la face de dessus 128 de la carte à circuit imprimé 126 sous des détecteurs de position 24. Plus particulièrement, les éléments de détections 122, 124 sont de forme annulaire et sont intercalés entre les détecteurs de position 24 de forme annulaire et la face de dessus 128 de la carte à circuit imprimé 126. Selon le mode de réalisation, la carte à circuit imprimé 126 comporte uniquement deux éléments de détections 122, 124 agencés symétriquement de part et d'autre de la médiane transversale MT de la carte à circuit imprimé 126, et en vis-à-vis direct de la zone médiane transversale 130 de la carte à circuit imprimé 126.

L'élément de commande de commande 132 ne comporte aucun bras d'appui venu de matière avec la dite plaque de commande 56. La liaison mécanique entre la plaque de commande 56 et les éléments de détection 122, 124 permettant aux éléments de détection 122, 124 d'agir aussi bien en capteur de force d'appui qu'en actionneur haptique est réalisée par les deux détecteurs de positions 24 sous lesquels sont agencés les éléments de détection 122, 124.

Bien que la carte à circuit imprimé 126 soit représentée sans languettes élastiques, il est également possible d'agencer des découpes dans la carte à circuit imprimé 126 autour des éléments de détection 122, 124 annulaires afin de former des languettes élastiques.

Il est possible de réaliser une multitude d'autres modes de réalisation selon lesquels la forme des détecteurs de positions n'est pas annulaire et également selon lesquelles les détecteurs de positions sont de types autres que des capteurs à détection capacitive, comme par exemple des capteurs à détection résistive.

D'autres modes de réalisations sont également possible, pour lesquels l'ensemble de commande se limite à une carte à circuit imprimé comportant au minimum une série d'au moins deux détecteurs de position et un élément de détection, les détecteurs de position étant monté en appui contre l'élément de commande, et l'élément de détection étant intercalé en appui entre la carte à circuit imprimé et un organe de liaison, l'organe de liaison, tel un bras d'appui, étant en contact direct avec l'élément de commande. Les languettes élastiques, ainsi que les éléments de support de la carte à circuit imprimé permettent d'améliorer le fonctionnement des éléments de détections, c'est-à-dire d'améliorer la détection de la force d'appui lors du glissement d'un doigt d'un opérateur sur la zone de commande et d'améliorer la perception de retour de force par l'opérateur.

Tous les modes de réalisation représentés permettent d'obtenir un ensemble de commande par contact glissant de faible épaisseur selon l'axe vertical et de permettre une intégration aisée dans de nombreux modules électroniques de commandes de l'habitacle d'un véhicule. On notera plus particulièrement l'utilisation d'un tel panneau de commande pour des modules électroniques de plafond de véhicule généralement destiné à l'éclairage de l'habitacle du véhicule ou encore à l'utilisation d'un tel panneau de commande pour les modules frontaux de commande électronique de véhicule telle que les commandes du dispositif multimédia ou encore de climatisation du véhicule.

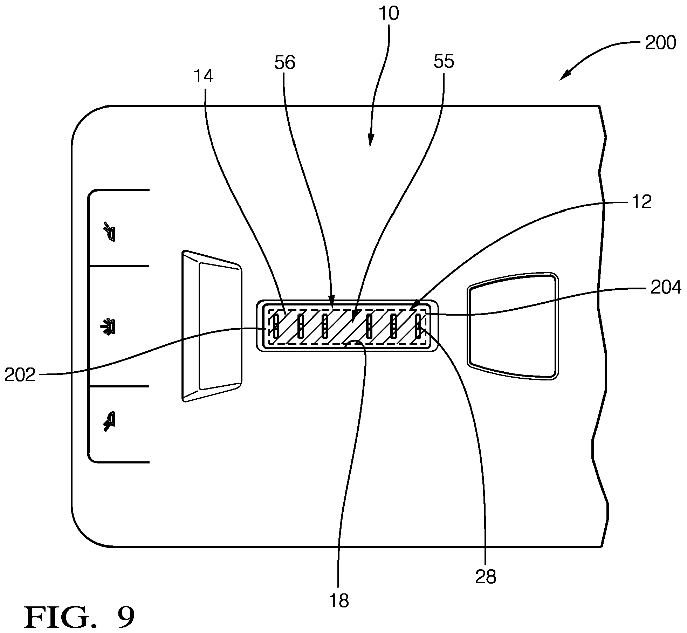

Selon la figure 9, un mode réalisation d'un module électronique de plafond 200 d'habitacle de véhicule est représenté. Ce module 200 est généralement destiné à l'éclairage des places avant du véhicule. Le module électronique de plafond 200 comporte le panneau de commande 10 équipé de n'importe lequel des ensembles de commande des modes de réalisation décrit. Il comporte trois touches de commande d'éclairage et une touche de commande 12 à contact glissant. La touche de commande 12 à contact glissant comporte l'un quelconque des ensembles de commande des modes de réalisation décrit par les figures 1, 2, 3, 4, 5, 6, 7 et 8. L'élément de commande 18 est agencé dans l'ouverture 14 du panneau de commande 10 permettant à un opérateur d'avoir accès à la zone de commande 55 par glissement.

Le glissement d'un doigt d'un opérateur sur la touche de commande 12 à contact glissant peut permettre l'activation de une à six sources de lumière 28 par glissement du doigt depuis une extrémité transversale 202 de la zone de commande 55 vers l'autre extrémité 204. L'intensité lumineuse peut être ajustée au regard de la force d'appui. Un acquittement de la commande effectuée est possible par un effet de retour de force sur la plaque de commande 56 de sorte à être perceptible par l'opérateur.

Selon l'invention, une méthode de commande de l'ensemble de commande 16 par contact glissant pour véhicule automobile peut comprendre plusieurs étapes, notamment une étape de détermination de l'appui d'un doigt sur la zone de commande 55 au moyen de la série de détecteurs de position 25, plus particulièrement, au moyen d'au moins un capteur à détection capacitive détectant la présence du doigt de l'opérateur. Afin de confirmer cet appui, et donc de réduire considérablement les fausses détections d'appui, la méthode comprend une étape de validation de l'appui du doigt sur la zone de commande 55 au moyen d'un élément de détection 34 différent de la série de détecteurs de position 25. Plus particulièrement, l'élément de détection 34 peut être un élément piézoélectrique dont la déformation par l'appui du doigt permet de valider le dit appui et également de déterminer la force d'appui du doigt sur la zone de commande 55. La méthode comprend également une étape de détection du glissement du doigt de l'opérateur sur la zone de commande 55 au moyen de la série de détecteurs de position 25, plus particulièrement, au moyen de la série de capteurs à détection capacitive. La méthode comprend la génération d'un signal haptique d'acquittement du glissement du doigt sur la zone de commande 55 au moyen de l'élément de détection 34, plus particulièrement au moyen de l'élément piézoélectrique agissant en tant qu'actionneur haptique. Enfin, la méthode comprend une étape d'activation d'une commande du véhicule en fonction de la course de glissement du doigt sur la zone de commande 55, c'est-à-dire en fonction de la distance parcourue par le doigt en glissant sur la zone de commande 55.

## Revendications

1. Ensemble de commande (16) par contact glissant pour véhicule automobile comprenant
un support (22);
une carte à circuit imprimé (20) agencée sur le support (22);
un élément de commande (18) recouvrant la carte à circuit imprimé (20) et comprenant une zone de commande (55) par glissement d'un doigt d'un opérateur ;
la carte à circuit imprimé (20) comprenant une première série de détecteurs de position (25) configurée pour déterminer la position et la direction de glissement du doigt d'un opérateur, la première série de détecteurs de position (25) étant montée en appui contre l'élément de commande (18) en vis-à-vis de la zone de commande (55) par glissement ;
la carte à circuit imprimé (20) comprend au moins un premier élément de détection (34) étant à la fois un capteur de force d'appui et un actionneur haptique, le premier élément de détection (34) étant intercalé en appui entre la carte à circuit imprimé (20) et un organe de liaison (61), l'organe de liaison (61) étant en contact direct avec l'élément de commande (18) ;
la carte à circuit imprimé (20) comprend une première découpe formant une première languette (44) élastique sur laquelle est agencé le premier élément de détection (34).

2. Ensemble de commande (16) selon l'une quelconque des revendications précédentes **caractérisé en ce que** chaque élément de détection (34) est un élément piézoélectrique.

3. Ensemble de commande (16) selon l'une quelconque des revendications précédentes **caractérisé en ce que** la première série de détecteurs de position (25) comprend des capteurs à détection capacitive.

4. Ensemble de commande (16) selon l'une quelconque des revendications précédentes **caractérisé en ce que**
la carte à circuit imprimé (20) est globalement rectangulaire selon un axe longitudinal (L) et un axe transversal (T),
l'élément de commande (18) comprend une plaque de commande (56) globalement rectangulaire sur laquelle la zone de commande (55) s'étend longitudinalement de sorte à détecter un glissement de doigt sur la zone de commande (55) selon la direction longitudinale.

5. Ensemble de commande (16) selon la revendication 4 **caractérisé en ce que** la zone médiane transversale (42) de la carte à circuit imprimé (20) est agencée en appui sur une barre de support transversale (78) comprenant un profil saillant sur le support (22) et **en ce que** les extrémités transversales (30, 32) de la carte à circuit imprimé (20) sont plaquées sur le support (22) de sorte que la carte à circuit imprimé (20) présente un profil courbé.

6. Ensemble de commande (16) selon l'une quelconque des revendications 4 et 5 **caractérisé en ce qu'**il comprend une seconde série de détecteurs de position (27) agencée symétriquement à la première série de détecteurs de position (25) par rapport à la médiane transversale (MT) de la carte à circuit imprimé (20) et un second élément de détection (38) agencé symétriquement au premier élément de détection (34) par rapport à la médiane transversale (MT) de la carte à circuit imprimé (20).

7. Ensemble de commande (16) selon la revendication 6 **caractérisé en ce que** la carte à circuit imprimé (20) comprend une seconde découpe formant une seconde languette (48) élastique sur laquelle est agencé le second élément de détection (38).

8. Ensemble de commande (16) selon l'une quelconque des revendications 6 et 7 **caractérisé en ce que** l'organe de liaison (61) comprend un premier bras d'appui (62) venu de matière avec l'élément de commande (18) et agencé contre le premier élément de détection (34) et le second élément de détection (38).

9. Ensemble de commande (16) selon l'une quelconque des revendications 6 à 8 **caractérisé en ce qu'**il comprend un troisième élément de détection (36) et un quatrième élément de détection (40) agencés respectivement symétriquement au premier élément de détection (34) et au second élément de détection (38), par rapport à la médiane longitudinale (ML) de la carte à circuit imprimé (20).

10. Ensemble de commande (16) selon la revendication 9 **caractérisé en ce que** la carte à circuit imprimé (20) comprend une troisième découpe et une quatrième découpe formant une troisième languette (46) élastique et une quatrième languette (50) élastique sur lesquelles sont agencés le troisième élément de détection (36) et le quatrième élément de détection (40).

11. Ensemble de commande (16) selon l'une quelconque des revendications 9 et 10 **caractérisé en ce que** l'organe de liaison (61) comprend un second bras d'appui venu de matière avec l'élément de commande (18) et agencé contre le troisième élément de détection (36) et le quatrième élément de détection (40).

12. Ensemble de commande (16) selon l'une quelconque des revendications 1 à 7 **caractérisé en ce que** l'organe de liaison (61) comprend au moins un détecteur de position (24).

13. Ensemble de commande (16) selon l'une quelconque des revendications 1 à 7 **caractérisé en ce que** l'organe de liaison (61) comprend au moins une barre de support (102) ayant un profil saillant sur le support (22), chaque élément de détection (34) étant agencé sur une barre de support (102), l'élément de commande (18) comprenant des moyens de fixation (114) avec le support (22).

14. Ensemble de commande (16) selon la revendication 13 **caractérisé en ce que** les moyens de fixations (114) sont des tiges de maintien s'étendant depuis l'élément de commande (18) jusqu'à leur extrémité libre, chaque extrémité libre comprenant un ergot (118) venant s'agencer au travers d'ouvertures du support (120) et venant en butée contre la face inférieure du support (112) de sorte à maintenir la carte à circuit imprimé (20) comprimée entre l'élément de commande (18) et le support (22).

15. Module électronique de plafond (200) d'habitacle de véhicule automobile comprenant l'ensemble de commande (16) selon l'une quelconque des revendications précédentes.

16. Méthode de commande d'un ensemble de commande (16) par contact glissant selon l'une quelconque des revendications 1-14 comprenant les étapes de :
déterminer l'appui d'un doigt sur la zone de commande (55) au moyen d'un capteur à détection capacitive ;
valider l'appui du doigt sur la zone de commande (55) au moyen d'un élément piézoélectrique agencé sur une languette élastique (44) de la carte à circuit imprimé (20);
déterminer la force d'appui du doigt sur la zone de commande (55) au moyen de l'élément piézoélectrique ;
détecter le glissement d'un doigt sur la zone de commande (55) au moyen d'une série de capteurs à détection capacitive ;
générer un signal haptique d'acquittement du glissement du doigt sur la zone de commande (55) au moyen de l'élément piézoélectrique ;
activer une commande du véhicule en fonction de la course de glissement du doigt sur la zone de commande (55).

## Patentansprüche

1. Bedieneinheit (16) mit Gleitkontakt für Kraftfahrzeuge, umfassend
eine Halterung (22);
eine auf der Halterung (22) gestaltete Leiterplatte (20); ein Bedienelement (18), das die Leiterplatte (20) abdeckt und einen Gleitbedienungsbereich (55) für einen Finger eines Bedieners umfasst;
wobei die Leiterplatte (20) eine erste Reihe von Positionssensoren (25) umfasst, die so konfiguriert sind, dass sie die Position und die Gleitrichtung des Fingers eines Bedieners bestimmen, wobei die erste Reihe von Positionssensoren (25) am Bedienelement (18) anliegend gegenüber dem Gleitbedienungsbereich (55) montiert ist;
die Leiterplatte (20) zumindest ein erstes Sensorelement (34) umfasst, das sowohl ein Auflagekraftsensor als auch ein haptisches Stellglied ist, wobei das erste Sensorelement (34) zwischen der Leiterplatte (20) und einem Verbindungskörper (61) anliegend angeordnet ist, wobei der Verbindungskörper (61) mit dem Bedienelement (18) in direkter Berührung steht;
die Leiterplatte (20) einen ersten Ausschnitt aufweist, der eine erste elastische Zunge (44) bildet, auf der das erste Sensorelement (34) angeordnet ist,

2. Bedieneinheit (16) nach einem beliebigen der vorstehenden Ansprüche, **dadurch gekennzeichnet, dass** jedes Sensorelement (34) ein piezoelektrisches Element ist.

3. Bedieneinheit (16) nach einem beliebigen der vorstehenden Ansprüche, **dadurch gekennzeichnet, dass** die erste Reihe von Positionssensoren (25) kapazitive Erkennungssensoren umfasst.

4. Bedieneinheit (16) nach einem beliebigen der vorstehenden Ansprüche, **dadurch gekennzeichnet, dass**
die Leiterplatte (20) im Allgemeinen rechteckig entlang einer Längsachse (L) und einer Querachse (T) ist,
das Bedienelement (18) eine im Allgemeinen rechteckige Betätigungsplatte (56) umfasst, auf der sich der Gleitbedienungsbereich (55) längs erstreckt, um ein Gleiten eines Fingers auf dem Gleitbedienungsbereich (55) in Längsrichtung zu erkennen.

5. Bedieneinheit (16) nach Anspruch 4, **dadurch gekennzeichnet, dass** der transversale Mittelbereich (42) der Leiterplatte (20) auf einer Querstützstange (78) anliegend gestaltet ist, die ein vorstehendes Profil auf der Halterung (22) aufweist, und dass die transversalen Enden (30, 32) der Leiterplatte (20) auf der Halterung (22) aufgelegt sind, so dass die Leiterplatte (20) ein gekrümmtes Profil aufweist.

6. Bedieneinheit (16) nach einem beliebigen der vorstehenden Ansprüche 4 und 5, **dadurch gekennzeichnet, dass** sie eine zweite Reihe von Positionssensoren (27) umfasst, die symmetrisch zur ersten Reihe von Positionssensoren (25) in Bezug auf den transversalen Mittelbereich (MT) der Leiterplatte (20) angeordnet sind, und ein zweites Sensorelement (38), das symmetrisch zum ersten Sensorelement (34) in Bezug auf den transversalen Mittelbereich (MT) der Leiterplatte (20) angeordnet ist.

7. Bedieneinheit (16) nach Anspruch 6, **dadurch gekennzeichnet, dass** die Leiterplatte (20) einen zweiten Ausschnitt aufweist, der eine zweite elastische Zunge (48) bildet, auf der das zweite Sensorelement (38) angeordnet ist.

8. Bedieneinheit (16) nach einem beliebigen der vorstehenden Ansprüche 6 und 7, **dadurch gekennzeichnet, dass** der Verbindungskörper (61) einen ersten Stützarm (62) integral mit dem Bedienelement (18) umfasst und gegen das erste Sensorelement (34) und das zweite Sensorelement (38) gestaltet ist.

9. Bedieneinheit (16) nach einem beliebigen der vorstehenden Ansprüche 6 bis 8, **dadurch gekennzeichnet, dass** sie ein drittes Sensorelement (36) und ein viertes Sensorelement (40) umfasst, die jeweils symmetrisch zum ersten Sensorelement (34) und zum zweiten Sensorelement (38) in Bezug auf den Längsmittelbereich (ML) der Leiterplatte (20) gestaltet sind.

10. Bedieneinheit (16) nach Anspruch 9, **dadurch gekennzeichnet, dass** die Leiterplatte (20) einen dritten Ausschnitt und einen vierten Ausschnitt umfasst, die eine dritte elastische Zunge (46) und eine vierte elastische Zunge (50) bilden, auf denen das dritte Sensorelement (36) und das vierte Sensorelement (40) gestaltet sind.

11. Bedieneinheit (16) nach einem beliebigen der vorstehenden Ansprüche 9 und 10, **dadurch gekennzeichnet, dass** der Verbindungskörper (61) einen zweiten Stützarm integral mit dem Bedienelement (18) umfasst und gegen das dritte Sensorelement (36) und das vierte Sensorelement (40) gestaltet ist.

12. Bedieneinheit (16) nach einem beliebigen der vorstehenden Ansprüche 1 bis 7, **dadurch gekennzeichnet, dass** der Verbindungskörper (61) zumindest einen Positionssensor (24) umfasst.

13. Bedieneinheit (16) nach einem beliebigen der vorstehenden Ansprüche 1 bis 7, **dadurch gekennzeichnet, dass** der Verbindungskörper (61) zumindest eine Stützstange (102) mit einem vorstehenden Profil auf der Halterung (22) umfasst, wobei jedes Sensorelement (34) auf einer Stützstange (102) gestaltet ist, wobei das Bedienelement (18) Befestigungsmittel (114) mit der Halterung (22) umfasst.

14. Bedieneinheit (16) nach Anspruch 13, **dadurch gekennzeichnet, dass** die Befestigungsmittel (114) Haltestangen sind, die sich vom Bedienelement (18) bis zu ihrem freien Ende erstrecken, wobei jedes freie Ende einen Stift (118) umfasst, der durch Öffnungen in der Halterung (120) hindurch gestaltet ist und an der Unterseite der Halterung (112) anliegt, um die zwischen dem Bedienelement (18) und der Halterung (22) eingebördelte Leiterplatte (20) zu halten.

15. Elektronisches Deckenmodul (200) des Innenraums eines Kraftfahrzeugs, das die Bedieneinheit (16) nach einem beliebigen der vorstehenden Ansprüche umfasst.

16. Verfahren zur Bedienung einer Bedieneinheit (16) mit Gleitkontakt nach einem beliebigen der vorstehenden Ansprüche 1-14, das die folgenden Schritte umfasst:
Bestimmen des Drucks eines Fingers auf dem Gleitbedienungsbereich (55) mittels eines kapazitiven Erkennungssensors;
Bestätigen des Fingerdrucks auf dem Gleitbedienungsbereich (55) vermittels eines piezoelektrischen Elements, das auf einer elastischen Zunge (44) der Leiterplatte (20) gestaltet ist;
Bestimmen der Auflagekraft des Fingers auf dem Gleitbedienungsbereich (55) vermittels des piezoelektrischen Elements;
Erkennen des Gleitens eines Fingers auf dem Gleitbedienungsbereich (55) vermittels einer Reihe von kapazitiven Erkennungssensoren;
Erzeugen eines haptischen Signals zum Quittieren des Gleitens des Fingers auf dem Gleitbedienungsbereich (55) vermittels des piezoelektrischen Elements;
Aktivieren einer Fahrzeugbedienung je nach dem Gleithub des Fingers auf dem Gleitbedienungsbereich (55).

## Claims

1. A control assembly (16) by sliding contact for a motor vehicle comprising:
- a support (22);
- a printed circuit board (20) arranged on the support (22) ;
- a control element (18) covering the printed circuit board (20) and comprising a control area (55) by the sliding of an operator's finger;
the printed circuit board (20) comprising a first series of position sensors (25) configured to determine the position and direction of sliding of an operator's finger, the first series of position sensors (25) being mounted to bear against the control element (18) vis-à-vis the control area (55) by sliding;
the printed circuit board (20) comprises at least a first detection element (34) being both a bearing force sensor and a haptic actuator, the first detection element (34) being interposed to bear between the printed circuit board (20) and a connection member (61), the connection member (61) being in direct contact with the control element (18);
the printed circuit board (20) comprises a first cut forming a first elastic tab (44) on which the first detection element (34) is arranged.

2. The control assembly (16) according to any one of the preceding claims **characterized in that** each detection element (34) is a piezoelectric element.

3. The control assembly (16) according to any one of the preceding claims, **characterized in that** the first series of position sensors (25) comprises sensors with capacitive detection.

4. The control assembly (16) according to any one of the preceding claims **characterized in that**:
the printed circuit board (20) is generally rectangular along a longitudinal axis (L) and a transverse axis (T),
the control element (18) comprises a generally rectangular control plate (56) on which the control area (55) extends longitudinally so as to detect a finger sliding on the control area (55) along the longitudinal direction.

5. The control assembly (16) according to claim 4 **characterized in that** the transverse median area (42) of the printed circuit board (20) is arranged to bear on a transverse support bar (78) comprising a profile protruding on the support (22) and **in that** the transverse ends (30, 32) of the printed circuit board (20) are plated on the support (22) so that the printed circuit board (20) has a curved profile.

6. The control assembly (16) according to any one of claims 4 and 5 **characterized in that** it comprises a second series of position sensors (27) arranged symmetrically with the first series of position sensors (25) relative to the transverse median (MT) of the printed circuit board (20) and a second detection element (38) arranged symmetrically with the first detection element (34) relative to the transverse median (MT) of the printed circuit board (20).

7. The control assembly (16) according to claim 6 **characterized in that** the printed circuit board (20) comprises a second cut forming a second elastic tab (48) on which the second detection element (38) is arranged.

8. The control assembly (16) according to any one of claims 6 and 7 **characterized in that** the connection member (61) comprises a first bearing arm (62) formed integrally with the control element (18) and arranged against the first detection element (34) and the second detection element (38).

9. The control assembly (16) according to any one of claims 6 to 8 **characterized in that** it comprises a third detection element (36) and a fourth detection element (40) arranged respectively symmetrically with the first detection element (34) and with the second detection element (38), relative to the longitudinal median (ML) of the printed circuit board (20).

10. The control assembly (16) according to claim 9 **characterized in that** the printed circuit board (20) comprises a third cut and a fourth cut forming a third elastic tab (46) and a fourth elastic tab (50) on which the third detection element (36) and the fourth detection element (40) are arranged.

11. The control assembly (16) according to any one of claims 9 and 10 **characterized in that** the connection member (61) comprises a second bearing arm formed integrally with the control element (18) and arranged against the third detection element (36) and the fourth detection element (40).

12. The control assembly (16) according to any one of claims 1 to 7 **characterized in that** the connection member (61) comprises at least one position sensor (24).

13. The control assembly (16) according to any one of claims 1 to 7 **characterized in that** the connection member (61) comprises at least one support bar (102) having a protruding profile on the support (22), each detection element (34) being arranged on a support bar (102), the control element (18) comprising fastening means (114) with the support (22).

14. The control assembly (16) according to claim 13 **characterized in that** the fastening means (114) are holding rods extending from the control element (18) up to their free end, each free end comprising a lug (118) arranged through openings of the support (120) and abutting against the lower face of the support (112) so as to maintain the printed circuit board (20) compressed between the control element (18) and the support (22).

15. An electronic ceiling module (200) of a motor vehicle interior comprising the control assembly (16) according to any one of the preceding claims.

16. A method for controlling a control assembly (16) by sliding contact according to any one of claims 1 to 14 comprising the steps of:
- determining the bearing of a finger on the control area (55) by means of a sensor with capacitive detection;
- validating the bearing of the finger on the control area (55) by means of a piezoelectric element arranged on an elastic tab (44) of the printed circuit board (20);
- determining the bearing force of the finger on the control area (55) by means of the piezoelectric element;
- detecting the sliding of a finger on the control area (55) by means of a series of sensors with capacitive detection;
- generating a haptic signal of acknowledgment of the sliding of the finger on the control area (55) by means of the piezoelectric element;
- activating a control of the vehicle based on the sliding stroke of the finger on the control area (55).
